# EUROPÄISCHE PATENTANMELDUNG

(11) **EP 4 773 184 A1**
(43) Veröffentlichungstag der Anmeldung: **08.07.2026**
(21) Anmeldenummer: 25150008.8
(22) Anmeldetag: 02.01.2025
(51) Int. Cl.: H01L 23/34, A47J 43/07

(54) **KÜHLVORRICHTUNG FÜR EINE KÜCHENMASCHINE**

(71) Anmelder: Vorwerk & Co. Interholding GmbH, 42275 Wuppertal (DE)
(72) Erfinder: MOSQUERA MICHAELSEN, Pablo, 45473 Mülheim (DE); ZABBACK, Iris, 42289 Wuppertal (DE); VAHLDIEK, Utz, 58332 Schwelm (DE)
(74) Vertreter: Bals & Vogel Patentanwälte PartGmbB

(57) **Zusammenfassung**

Die Erfindung betrifft eine Kühlkörpererweiterung (100) für eine Küchenmaschine (200), aufweisend:
- einen Wärmeaufnahmebereich (10), der thermisch leitend mit einem zu kühlenden Elektronikabschnitt (210) einer Küchenmaschine (200) verbindbar ist,
- einen Wärmeabgabebereich (30), der thermisch leitend mit einem wärmeabführenden Arbeitsabschnitt (230) der Küchenmaschine (200) verbindbar ist,
- einen Übergangsbereich (20), der den Wärmeaufnahmebereich (10) und den Wärmeabgabebereich (30) thermisch leitend verbindet und dazu eingerichtet ist, Wärme von dem Wärmeaufnahmebereich (10) an den Wärmeabgabebereich (30) zu leiten.

Weiterhin betrifft die Erfindung eine Küchenmaschine (200) und ein Montageverfahren.

## Beschreibung

Die Erfindung betrifft eine Kühlkörpererweiterung mit den Merkmalen des unabhängigen Patentanspruchs betreffend eine Kühlkörpererweiterung, eine Küchenmaschine mit den Merkmalen des unabhängigen Patentanspruchs betreffend eine Küchenmaschine sowie ein Montageverfahren mit den Merkmalen des unabhängigen Verfahrensanspruchs.

Bereits bekannt sind Küchenmaschinen, welche zum Zubereiten von (warmen) Speisen eingerichtet sind. Dabei kann ein (elektrischer) Motor verwendet werden, um ein darüber angeordnetes (und mit diesem verbundenes) Kochgefäß in eine Rotationsbewegung zu versetzen. Zudem kann eine Heizung vorgesehen sein, um das Kochgefäß zu temperieren, insbesondere zu beheizen. Zudem sind Elektronikeinheiten bekannt, welche zum Betreiben, insbesondere zum Steuern und/oder Regeln der Küchenmaschine vorgesehen sind, beispielsweise kann dadurch der Motor und/oder die Heizung kontrolliert werden.

Der Stand der Technik weist dabei Nachteile auf. So ist keine oder keine optimale Temperierung, insbesondere ein Wärmeabtransport, für die Küchenmaschine und/oder einzelner Abschnitte (z.B. Teilvolumina, wie ein Elektronikabschnitt) der Küchenmaschine vorgesehen. Beispielsweise kann eine im Elektronikabschnitt der Küchenmaschine entstandene Wärme nicht oder nur aktiv abgeführt werden. Auch kann eine Herstellung und/oder Montage kompliziert und/oder kostenintensiv sein. Zudem ist es nicht vorgesehen, für unterschiedliche Kühlkörper einen effizienten Wärmeabtransport zu ermöglichen. Weiterhin kann die Stabilität der Küchenmaschinen optimierbar sein. Außerdem können Toleranzen bei thermisch leitenden Verbindungen unzureichend sein. Auch kann die thermische und/oder thermodynamische Effizienz der Küchenmaschinen verbesserungswürdig sein.

Es ist daher eine Aufgabe der vorliegenden Erfindung, wenigstens einen der voranstehend beschriebenen Nachteile zumindest teilweise zu überwinden. Insbesondere ist es Aufgabe der Erfindung, einen verbesserten Wärme(ab)transport bereitzustellen, insbesondere für einen Elektronikabschnitt der Küchenmaschine. Es kann auch eine Aufgabe sein, eine besser temperierbare, effizientere, kostengünstigere, weniger komplizierte, leichter herstellbare, leichter montierbare und/oder stabilere Küchenmaschine bereitzustellen.

Die voranstehende Aufgabe wird gelöst durch eine Kühlkörpererweiterung mit den Merkmalen des unabhängigen Patentanspruchs betreffend eine Kühlkörpererweiterung, eine Küchenmaschine mit den Merkmalen des unabhängigen Patentanspruchs betreffend eine Küchenmaschine sowie ein Montageverfahren mit den Merkmalen des unabhängigen Verfahrensanspruchs. Weitere Merkmale und Details der Erfindung ergeben sich aus den Unteransprüchen, der Beschreibung und den Zeichnungen. Dabei gelten Merkmale und Details, die im Zusammenhang mit der erfindungsgemäßen Kühlkörpererweiterung beschrieben sind, selbstverständlich auch im Zusammenhang mit der erfindungsgemäßen Küchenmaschine und/oder im Zusammenhang mit dem erfindungsgemäßen Montageverfahren und jeweils umgekehrt, so dass bezüglich der Offenbarung zu den einzelnen Erfindungsaspekten stets wechselseitig Bezug genommen wird bzw. werden kann. Insbesondere gelten Vorteile, die im Rahmen des ersten, zweiten und/oder dritten Aspekts beschrieben werden, auch jeweils für den ersten, zweiten und/oder dritten Aspekt.

Die obenstehende Aufgabe wird gemäß einem ersten Aspekt gelöst durch eine Kühlkörpererweiterung für eine Küchenmaschine (vorzugsweise gemäß dem zweiten Aspekt), aufweisend:
- einen Wärmeaufnahmebereich, der thermisch leitend mit einem zu kühlenden Elektronikabschnitt einer Küchenmaschine verbindbar (und/oder verbunden) ist,
- einen Wärmeabgabebereich, der thermisch leitend mit einem wärmeabführenden Arbeitsabschnitt der Küchenmaschine verbindbar (und/oder verbunden) ist,
- einen Übergangsbereich, der den Wärmeaufnahmebereich und den Wärmeabgabebereich thermisch leitend verbindet und dazu eingerichtet ist, Wärme von dem Wärmeaufnahmebereich an den Wärmeabgabebereich zu leiten.

Die Kühlkörpererweiterung kann als Erweiterung und/oder Anbindungsteil für zumindest einen Kühlkörper, beispielsweise einen ersten und/oder zweiten Kühlkörper der Küchenmaschine verstanden werden, insbesondere zur Kontaktierung und/oder für eine (thermisch leitendende) Verbindung eines Elektronikabschnitts der Küchenmaschine. Dabei kann die Kühlkörpererweiterung ein separates Bauteil bilden, welches in der Küchenmaschine, vorzugsweise im Rahmen einer Montage, montiert werden kann. Ein montierter Zustand kann dabei eine (fertig) montierte Küchenmaschine bezeichnen, in welcher vorzugsweise die Kühlkörpererweiterung eingebaut ist. Die Kühlkörpererweiterung kann dabei dreiteilig ausgebildet sein, insbesondere umfassend den Wärmeaufnahmebereich, den Übergangsbereich und den Wärmeabgabebereich, welche insbesondere jeweils aneinander angeordnet sind. Die Kühlkörpererweiterung kann einteilig, einstückig und/oder stoffschlüssig ausgestaltet sein, und insbesondere ein (zusammenhängendes) Material und/oder Werkstück aufweisen. Dadurch kann die Stabilität erhöht werden. Beispielsweise kann die Kühlkörpererweiterung ein Stanz- und/oder Biegeteil aufweisen. Dadurch kann eine besonders hohe Elastizität und/oder Robustheit ermöglicht werden. Es kann auch vorgesehen sein, dass die Kühlkörpererweiterung als Spritzgussteil gefertigt wird, was eine einfache Fertigung ermöglichen kann. Die Kühlkörpererweiterung umfasst vorzugsweise ein Material mit einer hohen Wärmeleitfähigkeit und/oder Biegsamkeit. Darüber hinaus umfasst sie vorzugsweise ein Metall, insbesondere Stahl oder Edelstahl, welches insbesondere sehr robust ist und/oder eine gute Wärmeleitfähigkeit, z. B. 50 W/(mK), aufweist, und/oder Aluminium, welches insbesondere leicht verarbeitbar ist und/oder eine sehr hohe Wärmeleitfähigkeit, z. B. 160 W/(mK), aufweist. Es kann vorgesehen sein, dass die Kühlkörpererweiterung eine konstante Dicke aufweist, was vorteilhafterweise eine einfache Fertigung und/oder optimierten Wärmetransport ermöglicht. Die Dicke der Kühlkörpererweiterung kann dabei 0,1 mm bis 100 mm aufweisen, insbesondere 0,5 mm bis 10 mm, beispielsweise 1,0 mm bis 2,5 mm, vorzugswese 1,3 bis 1,8 mm, besonders bevorzugt 1,4 bis 1,6 mm. Dadurch kann ein (guter) Kompromiss aus (vergleichsweise) hoher Wärmeleitfähigkeit (bzw. Wärmekapazität), Stabilität und/oder Gewicht ermöglicht werden. Im Rahmen der Erfindung kann, insbesondere zur Veranschaulichung, eine (vertikale) z-Richtung vorgesehen sein, welche insbesondere senkrecht zu einer Auflagefläche und/oder Erdoberfläche orientiert sein kann. Die z-Richtung ([von] unten / [nach] oben) kann senkrecht sein zu einer x-Richtung ([von] hinten / [nach] vorne) und/oder y-Richtung ([von] links / [nach] rechts), wobei diese vorzugsweise ein Rechthandsystem bilden. Dabei kann die y-Richtung vorzugsweise von links nach rechts weisend ausgestaltet sein, insbesondere kann ein Benutzer der Küchenmaschine und/oder der Kühlkörpererweiterung dabei (wenn er zur Bedienung vor der Küchenmaschine steht, um beispielsweise eine Anzeigeeinheit und/oder Eingabevorrichtung zu bedienen) das linke äußere Ende (der Küchenmaschine und/oder der Kühlkörpererweiterung) links vor sich sehen und/oder das rechte äußere Ende (der Küchenmaschine und/oder der Kühlkörpererweiterung) rechts vor sich sehen. Die x-Richtung kann dabei bevorzugt von einer Position hinter der Küchenmaschine und/oder der Kühlkörpererweiterung zu einer Position davor weisend ausgebildet sein. Beispielsweise kann ein Benutzer beim Bedienen der Küchenmaschine vor dieser stehen, wobei insbesondere die x-Richtung auf den Benutzer weisend orientiert ist. Dabei kann der Elektronikabschnitt vorzugsweise (bezogen auf den Benutzer) vor einem dahinterliegenden (und/oder [ab-] getrennten) Arbeitsabschnitt (umfassend einen Motor und/oder Motorraum) angeordnet sein. Sofern nicht anders angegeben, können sich Ortsangaben und/oder Beschreibungen auf einen montierten Zustand beziehen und/oder auf das x-y-z-Koordinatensystem. Vorzugsweise funktioniert die Kühlkörpererweiterung (ausschließlich) passiv, insbesondere also eingerichtet als (passiver) Wärmeleiter. Demnach kann die Kühlkörpererweiterung zum Wärmetransport eingerichtet sein. Dadurch kann, insbesondere über die geometrische Form der Kühlkörpererweiterung, die Wärmeverteilung und/oder der Wärme(ab)transport beeinflusst und/oder gesteuert werden.

Der Wärmeaufnahmebereich kann thermisch leitend (insbesondere wärmeführend und/oder eine Wärmeenergie transportierend) mit einem zu kühlenden Elektronikabschnitt, insbesondere einem (ersten und/oder zweiten) Kühlkörper, der Küchenmaschine verbunden sein. Dies kann insbesondere in einem montierten Zustand (nach vollständiger Beendigung einer Montage) der Fall sein. Der Wärmeaufnahmebereich kann bevorzugt für ein Aufnehmen von Wärme aus dem Elektronikabschnitt eingerichtet sein. Der Wärmeaufnahmebereich kann dabei (entlang der z-Richtung) oberhalb des Elektronikbereichs angeordnet sein und insbesondere den ersten und/oder zweiten Kühlkörper von oben kontaktieren. Der Elektronikabschnitt kann dabei eine Platine aufweisen, welche eine Vielzahl an elektronischen Bauteilen aufweist, beispielsweise eine Anzeigeeinheit (z. B Display), eine Eingabevorrichtung (z. B. für einen Benutzer), einen (oder mehrere) Transistor(en), Diode(n), Mosfet(s), Gleichrichter, eine Steuereinheit, eine (elektrische) Energieversorgung und/oder eine Heizung. Dabei kann der Elektronikabschnitt, insbesondere die Steuereinheit, zum Betreiben und/oder Steuern und/oder Regeln der Küchenmaschine, insbesondere von Motor, Heizung, und/oder Lüfter eingerichtet sein. Außerdem kann dabei eine Heizung zum Temperieren, insbesondere zum Heizen der Küchenmaschine, insbesondere eines Kochgefäßes, eingerichtet sein, beispielsweise zum Garen und/oder Kochen von Lebensmitteln innerhalb des Kochgefäßes. Alternativ oder zusätzlich kann die Heizung zumindest abschnittsweise im Arbeitsabschnitt, insbesondere an und/oder in der Wärmeaustauschfläche, angeordnet sein. Demnach kann der Elektronikabschnitt, insbesondere dessen Bestandteile, (jeweils) eine Wärme, insbesondere Abwärme und/oder thermische Energie bzw. Leistung erzeugen, insbesondere bei einem Betreiben (z. B. bei der Zubereitung von Mahlzeiten) der Küchenmaschine. Dies kann ein Kühlen erfordern. Die Kühlkörpererweiterung ist dafür eingerichtet, (die) Wärme (zumindest teilweise, vorzugsweise vollständig) abzuführen und/oder abzuleiten, insbesondere aus dem Elektronikabschnitt. Dadurch kann vorteilhafterweise die Funktionalität aufrechterhalten, der Verschleiß reduziert und/oder die Sicherheit erhöht werden (da dies insbesondere der Bereich ist, den der Benutzer berührt). Besonders bevorzugt kann die Wärme kaum oder nicht in und/oder (nahe) um den Elektronikabschnitt, sondern über den Arbeitsabschnitt abgegeben werden. Dadurch können beispielsweise der Elektronikabschnitt und/oder der vordere Bereich der Küchenmaschine, welcher bevorzugt von dem Benutzer (zum Bedienen) angefasst wird, (an der Oberfläche) kühl(er) gehalten werden. Dabei können die Sicherheit erhöht und/oder Verbrennungen vermieden werden. Zudem kann so vermieden werden, dass der Benutzer (aufgrund erhöhter) Temperatur erschrickt und/oder die Küchenmaschine verschiebt (oder gar umwirft). Bevorzugt wird Wärme (welche insbesondere im vorderen Bereich und/oder Elektronikabschnitt entsteht), (nur) im hinteren Bereich und/oder Arbeitsabschnitt abgeführt, und insbesondere (dort) an die Umgebung (der Küchenmaschine) abgegeben. Es kann vorgesehen sein, dass die Kühlkörpererweiterung und/oder der Elektronikabschnitt lüfterlos, insbesondere also ohne (aktiven) Lüfter (etwa ein Gebläse), eingerichtet sind. Dies kann vorteilhafterweise die Optik verbessern (keine Lüftungsschlitze) und/oder die Geräuschentwicklung reduzieren (welche insbesondere zwischen Arbeitsschritten ansonsten hörbar wäre). Vorzugsweise erstreckt sich der Wärmeaufnahmebereich über einen Großteil oder die gesamte Breite (in y-Richtung) der Küchenmaschine und/oder der Kühlkörpererweiterung. Dadurch kann ein besonders guter Wärmetransport ermöglicht werden. Vorzugsweise erstreckt sich der Wärmeaufnahmebereich über einen Großteil oder die gesamte Breite (in y-Richtung) des ersten und/oder zweiten Kühlkörpers der Küchenmaschine. Dadurch können ein besonders guter Wärmetransport sowie (gleichzeitig) eine einfache Montage ermöglicht werden.

Der Übergangsbereich, der den Wärmeaufnahmebereich und den Wärmeabgabebereich thermisch leitend verbindet und dazu eingerichtet ist, Wärme von dem Wärmeaufnahmebereich an den Wärmeabgabebereich zu leiten, kann dabei, insbesondere entlang der x-Richtung, zwischen (vor) dem Wärmeaufnahmebereich und (hinter) dem Wärmeabgabebereich angeordnet sein. Der Übergangsbereich kann stoffschlüssig mit dem Wärmeaufnahmebereich und/oder dem Wärmeabgabebereich verbunden sein, wodurch vorteilhafterweise eine (besonders) gute Wärmeleitfähigkeit ermöglicht wird. Vorzugsweise ist der Übergangsbereich flächig und/oder rechteckig ausgebildet, insbesondere mit abgerundeten Ecken. Vorzugsweise erstreckt sich der Übergangsbereich über einen Großteil oder die gesamte Breite (in y-Richtung) der Küchenmaschine und/oder der Kühlkörpererweiterung. Dadurch kann ein besonders guter Wärmetransport ermöglicht werden.

Der Wärmeabgabebereich, der thermisch leitend mit einem wärmeabführenden Arbeitsabschnitt der Küchenmaschine verbindbar (und/oder verbunden) ist, kann dabei in x-Richtung vor dem dahinterliegenden Übergangsbereich und/oder Wärmeaufnahmebereich angeordnet sein. Der Wärmeabgabebereich kann oberhalb des Motorraums und/oder unterhalb der Wärmeaustauschfläche angeordnet sein. Er kann stoffschlüssig mit dem Übergangsbereich verbunden sein, wodurch vorteilhafterweise eine (besonders) gute Wärmeleitfähigkeit ermöglicht wird. Vorzugsweise ist der Wärmeabgabebereich (zumindest abschnittsweise) flächig und/oder rechteckig ausgebildet, insbesondere mit abgerundeten Ecken. Vorzugsweise erstreckt sich der Wärmeabgabebereich über einen Großteil oder die gesamte Breite (in y-Richtung) der Küchenmaschine und/oder der Kühlkörpererweiterung. Dadurch kann ein besonders guter Wärmetransport und/oder eine Wärmeübertragung (an den Arbeitsbereich) ermöglicht werden. Der Wärmeabgabebereich kann eine oder (vorzugsweise mehrere) Rastöffnungen und/oder Rastnasen aufweisen, welche mit korrespondierenden Rastnasen und/oder Rastöffnungen der Küchenmaschine, insbesondere des Arbeitsbereichs (z. B. der Wärmeaustauschfläche), (reversibel lösbar) verbindbar (verbunden) sind. Dadurch kann eine stabile mechanische Verbindung hergestellt werden. Vorzugsweise kann der Wärmeabgabebereich thermisch leitend und/oder flächig mit dem Arbeitsbereich verbunden sein, insbesondere mit der Wärmeaustauschfläche und/oder dem Motorraum der Küchenmaschine. Dadurch kann (sowohl) an die Wärmeaustauschfläche und (auch) an den Motorraum Wärme abgegeben werden. Durch die Größe der jeweiligen (Ober-) Fläche, welche an die Wärmeaustauschfläche und/oder den Motorraum angrenzt, kann der Anteil der (an diese[n]) abgegebenen Wärme (zumindest teilweise) eingestellt werden.

Im Rahmen der Erfindung kann es von Vorteil sein, dass der Wärmeaufnahmebereich, der Wärmeabgabebereich und/oder der Übergangsbereich (zumindest abschnittsweise) flächig und/oder (zumindest abschnittsweise) planar ausgestaltet sind, wobei insbesondere in einem montierten Zustand der Wärmeaufnahmebereich und der Wärmeabgabebereich (im Wesentlichen) parallel anordbar sind.

Dabei können der Wärmeaufnahmebereich, der Wärmeabgabebereich und/oder der Übergangsbereich eine identische und/oder konstante Dicke aufweisen. Dies kann eine einfache Fertigung und/oder einen homogenen Wärmetransport (bzw. Wärmeverteilung) ermöglichen. Dabei kann die Kühlkörpererweiterung, insbesondere im montierten Zustand (in der Küchenmaschine), vorzugsweise senkrecht zur y-Richtung, terrassenförmig, z-förmig, s-förmig und/oder stufenförmig ausgestaltet sein. Der Wärmeaufnahmebereich kann dabei (entlang der z-Richtung) unterhalb des Übergangsbereichs und/oder des Wärmeabgabebereichs angeordnet sein. Dadurch kann der Elektronikabschnitt flacher als der Arbeitsabschnitt ausgeführt sein, was vorteilhafterweise eine verbesserte Optik (insbesondere mit flacherer und/oder angeschrägter Oberfläche [z. B. mit Anzeigeeinheit] im oberen Bereich des Elektronikbereichs) und/oder einen ausreichenden bzw. größeren Motorraum ermöglicht, wodurch insbesondere ein größerer Motor (mit mehr Leistung) verwendet und/oder die Kosten reduziert werden können. Durch eine flächige Ausgestaltung kann ein verbesserter Flammschutz bereitgestellt und/oder der Wärmetransport verbessert werden. Dabei können der Wärmeaufnahmebereich und/oder der Wärmeabgabebereich (zumindest teilweise) senkrecht zur z-Richtung und/oder parallel zum Boden (horizontal bzw. entlang x- und y-Richtung) angeordnet sein. Dadurch kann der Flammschutz weiter verbessert werden.

Im Rahmen der Erfindung ist es denkbar, dass der Übergangsbereich relativ zu dem Wärmeaufnahme- und/oder Wärmeabgabebereich abgewinkelt ausgestaltet ist, insbesondere in einem montierten Zustand, wobei vorzugsweise zwischen dem Übergangsbereich und dem Wärmeaufnahmebereich und/oder zwischen dem Übergangsbereich und dem Wärmeabgabebereich ein spitzer Winkel ausgebildet ist.

Dadurch kann der Elektronikabschnitt flacher und/oder niedriger als der Arbeitsabschnitt ausgeführt sein, was vorteilhafterweise eine verbesserte Optik (insbesondere mit flacherer und/oder angeschrägter Oberfläche [z. B. mit Anzeigeeinheit] im oberen Bereich des Elektronikbereichs) und/oder einen ausreichenden bzw. größeren Motorraum ermöglicht, wodurch insbesondere ein größerer Motor (mit mehr Leistung) verwendet und/oder die Kosten reduziert werden können. Weiterhin kann dadurch die Stabilität und/oder Steifigkeit der Kühlkörpererweiterung und/oder Küchenmaschine erhöht werden. So kann bei einem Sturz die Kühlkörpererweiterung, insbesondere aufgrund ihrer Form, zumindest einen Teil der Energie aufnehmen und/oder umverteilen, wodurch vorteilhafterweise der Elektronikabschnitt und/oder Motor weniger oder keinen Schaden nehmen. Dies kann (kostspielige) Reparaturen verhindern. Der spitze Winkel kann dabei (jeweils) zwischen 0 bis 90° aufweisen, insbesondere zwischen 1 bis 60°, beispielsweise zwischen 2 bis 45°, vorzugsweise zwischen 4 bis 30°, besonders bevorzugt zwischen 5 bis 20°, idealerweise zwischen 8 bis 15°. Dadurch kann ein Höhenunterschied zwischen Wärmeaufnahme- und Wärmeabgabebereich überbrückt werden, die Stabilität (und/oder Steifigkeit) erhöht werden und/oder eine schnelle Fertigung ermöglicht werden. Dabei kann (dadurch) eine vorteilhafte Optik der Küchenmaschine ermöglicht werden, insbesondere mit angeschrägtem Elektronikabschnitt.

Es kann im Rahmen der Erfindung vorgesehen sein, dass insbesondere in einem montierten Zustand der Wärmeaufnahmebereich, insbesondere relativ zu einer vertikalen z-Richtung, unterhalb des Wärmeabgabebereichs angeordnet ist und/oder der Übergangsbereich schräg dazwischenliegend angeordnet ist.

Demnach kann die Kühlkörpererweiterung stufenförmig ausgestaltet sein, wobei insbesondere der Übergangsbereich schräg zwischen Wärmeaufnahme- und Wärmeabgabebereich angeordnet ist.

Es ist ferner denkbar, dass die Kühlkörpererweiterung (zumindest abschnittsweise) L-förmig ausgestaltet ist, insbesondere senkrecht zu einer z-Richtung, welche sich senkrecht zu einer x- und einer y-Richtung erstreckt, wobei insbesondere an einer längeren Seite der Kühlkörpererweiterung der Wärmeaufnahmebereich, der Übergangsbereich und/oder der Wärmeabgabebereich anordbar sind.

Dabei kann vorzugsweise eine lange Seite (der L-Form) entlang der y-Richtung ausgebildet sein. Insbesondere können folgende Bauteile (im Wesentlichen) parallel und/oder entlang der y-Richtung angeordnet sein:
- die lange Seite (der L-Form),
- das erste Scharnier,
- das zweite Scharnier,
- der Wärmeaufnahmebereich (insbesondere eine Längserstreckung dessen),
- der Übergangsbereich (insbesondere eine Längserstreckung dessen),
- der Wärmeabgabebereich (insbesondere eine Längserstreckung dessen),
- die erste Lasche (insbesondere eine Längserstreckung dieser), und/oder
- die zweite Lasche (insbesondere eine Längserstreckung dieser).

Durch die L-Form kann eine besonders einfache Montage ermöglicht werden, insbesondere da ein Einsetzen der Kühlkörpererweiterung (beispielsweise im Vergleich zu einer umlaufenden und/oder U-Form) einseitig (entlang der y-Richtung) und/oder von oben (entgegen der z-Richtung) erfolgen kann. Dabei kann durch die L-Form die Kontaktfläche für eine Wärmeübertragung vergrößert werden. Vorzugsweise kann die Form der Kühlkörpererweiterung an einen Motorraum und/oder Motor angepasst sein, insbesondere komplementär. Dies kann eine höhere Stabilität und/oder eine optimierte Wärmeübertragung ermöglichen.

Auch ist es denkbar, dass der Übergangsbereich durch ein erstes Scharnier mit dem Wärmeaufnahmebereich, vorzugsweise stoffschlüssig, verbunden ist und/oder der Übergangsbereich durch ein zweites Scharnier, insbesondere stoffschlüssig, mit dem Wärmeabgabebereich verbunden ist.

Durch das erste und/oder zweite Scharnier kann die Flexibilität der Kühlkörpererweiterung verbessert werden. Dies kann verhindern, dass bei einem Sturz (zu große) Kräfte auf den Elektronikabschnitt, insbesondere den ersten und/oder zweiten Kühlkörper (sowie die Platine) übertragen werden, beispielsweise durch das Gehäuse und/oder den Arbeitsabschnitt. Gleichzeitig kann dadurch (dennoch) eine gute Stabilität und/oder Steifigkeit ermöglicht werden und/oder eine thermische Wärmeleitung (überhaupt) ermöglicht werden. Das erste und/oder zweite Scharnier können einstückig und/oder stoffschlüssig mit dem Wärmeaufnahmebereich, Übergangsbereich und/oder Wärmeabgabebereich verbunden sein. Dabei können das erste und/oder zweite Scharnier als Filmscharnier ausgestaltet sein. Dies ermöglicht eine einfache Fertigung, insbesondere um die obigen Vorteile zu ermöglichen. Ein stoffschlüssiges erstes und/oder zweites Scharnier ermöglicht dabei (insbesondere bei geringer und/oder reduzierter Dicke) eine (dennoch) hohe thermische Leitfähigkeit.

Im Rahmen der Erfindung ist es optional möglich, dass der Wärmeabgabebereich eine obere (nach oben weisende) Wärmeabgabefläche aufweist, welche dazu eingerichtet ist, in dem wärmeabführenden Arbeitsabschnitt der Küchenmaschine Wärme, insbesondere über eine Wärmeaustauschfläche (des Gehäuses) der Küchenmaschine, an die Umgebung abzugeben,und/oder eine untere (nach unten weisende) Wärmeabgabefläche aufweist, welche (jeweils) insbesondere dazu eingerichtet ist, in dem wärmeabführenden Arbeitsabschnitt der Küchenmaschine Wärme an einen, insbesondere temperierten und/oder (durch einen Lüfter und/oder ein auf einer Welle des Motors angeordneten Lüfterrad) belüfteten und/oder gekühlten, Motorraum (aufweisend einen Motor, welcher insbesondere zum Antreiben einer Drehwelle und/oder eines Drehmessers eingerichtet ist) der Küchenmaschine abzugeben. Alternativ (bevorzugt) oder zusätzlich kann es vorgesehen sein, dass die Küchenmaschine einen Lüftungskanal, insbesondere umfassend einen (elektrischen) Lüfter, aufweist, welcher dazu eingerichtet ist Wärme von der Wärmeaustauschfläche und/oder Wärmeabgabefläche aufzunehmen und aus der Küchenmaschine zu befördern. Dabei kann der Lüftungskanal beispielsweise von einem rechten (Einlass) zu einem linken Ende (Auslass) bzw. einer Seite des Gehäuses angeordnet sein, z. B. angrenzend und/oder (teilweise) umschließend an der Kühlkörpererweiterung. Vorzugsweise kann es vorgesehen sein, dass der Lüftungskanal (zumindest abschnittsweise) unterhalb der Kühlkörpererweiterung angeordnet ist, insbesondere unterhalb des zentralen Wärmeabgabebereichs. Besonders bevorzugt kann es sein, dass der Lüftungskanal an und/oder neben der ersten und/oder zweiten Lasche angeordnet ist. Alternativ oder zusätzlich kann es vorgesehen sein, dass der Lüftungskanal an und/oder neben dem ersten und/oder zweiten Kühlkörper (im montierten Zustand) angeordnet ist. Dadurch kann (jeweils) eine direkte und/oder optimale Wärmeabführung ermöglicht werden. Es kann vorgesehen sein, dass der Lüftungskanal, insbesondere zumindest abschnittsweise, eine zu der Kühlkörpererweiterung und/oder den (ersten und/oder zweiten) Kühlkörpern komplementäre Form aufweist. Dadurch kann die Wärmeübertragung verbessert werden und/oder die Kompaktheit optimiert werden. Es kann vorgesehen sein, dass der Lüftungskanal (zusätzlich) zur Kühlung des Motors verwendet wird. Der Motor kann, insbesondere auf einer Drehwelle des Motors, ein Lüfterrad aufweisen, welches (bei einer Drehung des Motors) dazu eingerichtet ist, den Motor zu kühlen. Dabei kann (gleichzeitig) eine Kühlung der Kühlkörpererweiterung und/oder des Lüftungskanals ermöglicht werden. Der Lüftungskanal kann einen Einlass aufweisen, welcher insbesondere mit der Umgebung verbunden ist. Der Einlass kann beispielsweise an einer rechten Seitenwand und/oder am Motorraum angeordnet sein. Der Lüftungskanal kann tunnelartig und/oder schlauchartig ausgestaltet sein. Dadurch kann Luft aus der Umgebung in den Lüftungskanal und/oder Motorraum gesaugt werden. Der Lüftungskanal kann (anschließend) zumindest abschnittsweise in dem Elektronikbereich angeordnet sein (siehe oben). Der Lüftungskanal kann anschließend wieder mit dem Motorraum verbunden sein und/oder über einen Auslass (z.B. an einer linken Seitenwand) mit der Umgebung. Bevorzugt kann Luft durch den Lüftungskanal über den Motor (bzw. ein entsprechendes sich mit dem Motor drehendes Lüfterrad) transportiert werden. Alternativ oder zusätzlich kann (schaltbar) ein zusätzlicher Lüfter an und/oder in dem Lüftungskanal verbaut sein (z. B. für Zeitintervalle in denen sich der Motor nicht dreht).

Dabei können der Wärmeabgabebereich, die untere Wärmeabgabefläche, die obere Wärmeabgabefläche und/oder die Wärmeaustauschfläche parallel angeordnet sein. Die obere Wärmeabgabefläche kann dabei Wärme an die Wärmeaustauschfläche abgeben, welche wiederum die Wärme an die insbesondere darüber befindliche Umgebung und/oder eine Heizplatte und/oder ein Rührgefäß abgeben kann. Dabei kann die obenliegende Wärmeaustauschfläche als Teil eines Gehäuses der Küchenmaschine ausgestaltet sein. Die Wärmeaustauschfläche kann dabei als Heizplatte ausgestaltet sein (ähnlich einer elektrischen Herdplatte) und/oder mit dem Rührgefäß der Küchenmaschine (zum Wärmeaustausch, insbesondere zum Beheizen von diesem) verbunden sein. Der Motorraum kann als Teil des Gehäuses ausgestaltet und/oder mit der Umgebung verbunden sein, insbesondere um Wärme an diese abzugeben. Beispielsweise kann Luft in der Umgebung das Gehäuse umgeben, wodurch das Gehäuse, insbesondere der Motorraum und/oder die Wärmeaustauschfläche, Wärme an die Umgebung abgeben können. Es kann auch vorgesehen sein, dass die Wärmeaustauschfläche und/oder (bevorzugt) der Motorraum einen Lüfter aufweisen, welcher für ein Temperieren, insbesondere ein Kühlen, eingerichtet ist. Dabei kann der Lüfter warme Luft aus dem Gehäuse, insbesondere dem Motorraum, an die Umgebung abgeben und/oder kühlere Luft aus der Umgebung ansaugen. Ein Lüfter kann dabei vorteilhafterweise technisch einfach, robust und/oder kostengünstig sein. Es kann auch vorgesehen sein, dass ein erster Lüfter Luft aus der Umgebung ansaugt und ein zweiter Lüfter Luft an die Umgebung ausgibt. Alternativ oder zusätzlich können die Wärmeaustauschfläche und/oder der Motorraum eine Wasserkühlung aufweisen. Dadurch kann vorteilhafterweise eine unerwünschte Geräuschentwicklung verhindert und/oder eine (vergleichsweise) hohe Kühlleistung ermöglicht werden. Dies kann insbesondere den Verschleiß reduzieren.

Ferner kann es im Rahmen der Erfindung vorgesehen sein, dass der Wärmeaufnahmebereich, insbesondere eine erste und/oder zweite Lasche des Wärmeaufnahmebereichs, dazu eingerichtet ist, durch ein Wärmeleitmittel, insbesondere ein erstes und/oder zweites Wärmeleitmittel, mit einem Kühlkörper, insbesondere einem ersten und/oder zweiten Kühlkörper, des zu kühlenden Elektronikabschnitts der Küchenmaschine verbunden zu werden.

Dabei kann es vorgesehen sein, dass der Wärmeaufnahmebereich, insbesondere eine erste und/oder zweite Lasche des Wärmeaufnahmebereichs, beabstandet (um einen Abstand) von dem Kühlkörper, insbesondere einem ersten und/oder zweiten Kühlkörper, angeordnet ist. Der Abstand der Kühlkörpererweiterung kann dabei 0,1 mm bis 10 mm aufweisen, insbesondere 0,2 mm bis 5 mm, beispielsweise 0,3 mm bis 1,0 mm, vorzugswese 0,4 bis 0,8 mm, besonders bevorzugt 0,5 bis 0,7 mm, idealerweise 0,6 mm. Der Abstand kann vorteilhafterweise eine einfache und/oder berührungsfreie Montage erlauben. Der Abstand kann zudem, insbesondere während der Montage, vorzugsweise nach einem Einfügen der Kühlkörpererweiterung mit einem ersten und/oder zweiten Wärmeleitmittel gefüllt werden. Dadurch kann eine thermisch leitende Verbindung und/oder mechanische (flexible) Befestigung zwischen dem Wärmeaufnahmebereich, insbesondere der ersten und/oder zweiten Lasche, und dem Kühlkörper, insbesondere dem ersten und/oder zweiten Kühlkörper, erzielt werden. Dies kann eine einfache Fertigung, einfache Montage, gute thermische Leitfähigkeit und/oder (gleichzeitig) Flexibilität, insbesondere zwischen Kühlkörper und Wärmeaufnahmebereich ermöglichen, was vorzugsweise (insgesamt) die Robustheit erhöht. Der erste und zweite Kühlkörper können im Elektronikabschnitt beabstandet, separat und/oder getrennt angeordnet sein und vorzugsweise unterschiedliche Abschnitte und/oder Bauteile des Elektronikabschnitts, insbesondere einer Platine, kühlen und/oder einen Wärmeabtransport ermöglichen. Das erste und/oder zweite Wärmeleitmittel kann bevorzugt für eine thermisch leitende Verbindung und/oder eine mechanische Befestigung, insbesondere eine unlösbare und/oder klebende Verbindung, eingerichtet sein. Das erste und/oder zweite Wärmeleitmittel kann als Wärmeleitpad, insbesondere Wärmeleitklebepad, ausgestaltet sein. Dies ermöglicht eine einfache und/oder schnelle Montage. Das erste und/oder zweite Wärmeleitmittel kann als Wärmeleitpaste und/oder Wärmeleitfolie (Wärmeleitübergangsfolie) ausgestaltet sein, wodurch vorteilhafterweise ein Ausgleich von (Fertigungs-) Toleranzen ermöglicht werden kann.

In Bezug auf die vorliegende Erfindung ist es vorstellbar, dass der Übergangsbereich eine Ausnehmung aufweist, welche dazu eingerichtet ist, zwei räumlich getrennte Übergangsbereiche, insbesondere einen ersten Übergangsbereich für eine erste Lasche und einen zweiten Übergangsbereich für eine zweite Lasche, bereitzustellen.

Die Ausnehmung kann dabei unterschiedliche, räumlich getrennte und/oder separierte Übergangsbereiche bereitstellen und/oder erzeugen, insbesondere links und rechts in y-Richtung. Die Ausnehmung kann länglich ausgebildet sein, insbesondere orientiert entlang der x-Richtung. Dabei kann die Kühlkörpererweiterung, insbesondere der Übergangsbereich im Bereich der Ausnehmung, unterbrochen sein, insbesondere entlang der x-Richtung. Mit anderen Worten kann es sich um einen Einschnitt handeln, welcher entlang (insbesondere entgegen) der x-Richtung ausgeführt wird. Durch die Ausnehmung kann vorteilhafterweise eine flexible Anordnung und/oder Positionierung des Übergangsbereichs, des Wärmeaufnahmebereichs, der ersten Lasche und/oder der zweiten Lasche ermöglicht werden, insbesondere bei einer Montage. Dabei kann die erste und/oder zweite Lasche an dem ersten und/oder zweiten Übergangsbereich angeordnet sein. Bevorzugt kann es vorgesehen sein, dass der Wärmeaufnahmebereich eine (und/oder die [gleiche]) Ausnehmung aufweist, welche dazu eingerichtet ist, zwei räumlich getrennte Wärmeaufnahmebereiche, insbesondere eine erste Lasche, und einen zweiten Wärmeaufnahmebereich, insbesondere eine zweite Lasche, bereitzustellen. Es kann auch vorgesehen sein, dass der Wärmeaufnahmebereich eine vergrößerte Ausnehmung aufweist, welche zumindest teilweise mit der Ausnehmung fluchtend angeordnet ist. Demnach kann mit anderen Worten der Wärmeaufnahmebereich über einen größeren Abschnitt (entlang der y-Richtung) eine (vergrößerte) Ausnehmung aufweisen als der Übergangsbereich. Dadurch können die erste und/oder zweite Lasche besonders flexibel (während der Montage) angeordnet werden. Somit können Toleranzen und/oder unterschiedlich angeordnete Kühlkörper, z. B. der erste und/oder zweite Kühlkörper einfacher und/oder zuverlässiger kontaktiert werden (über das erste und/oder zweite Wärmeleitmittel).

Ferner ist es vorstellbar, dass der Wärmeaufnahmebereich, insbesondere eine erste und/oder zweite Lasche, zumindest eine Aussparung aufweist, welche insbesondere rechteckig ausgestaltet ist.

Dabei kann die Aussparung in der ersten und/oder zweiten Lasche ausgebildet sein, vorzugsweise mittig und/oder senkrecht zur z-Richtung. Beispielsweise kann die Aussparung quaderförmig und/oder rechteckig (in Draufsicht) ausgestaltet sein. Dadurch kann beispielsweise ein Anordnen an einer komplementär ausgebildeten Rastnase des ersten und/oder zweiten Kühlkörpers erfolgen. Alternativ oder zusätzlich kann die Aussparung Raum für insbesondere ausgedehntes und/oder überschüssiges Wärmeleitmittel bereitstellen. So kann die Montage vereinfacht werden und/oder eine zuverlässigere Verbindung, insbesondere zwischen dem Wärmeaufnahmebereich und dem Kühlkörper, ermöglicht werden.

Im Rahmen der Erfindung kann es von Vorteil sein, dass der Wärmeaufnahmebereich, insbesondere eine erste und/oder zweite Lasche, einen Scharnierbereich aufweist, welcher dazu eingerichtet ist, insbesondere bei einer Montage, einen Haken, insbesondere einen ersten und/oder zweiten Haken eines Kühlkörpers, insbesondere eines ersten und/oder zweiten Kühlkörpers zu untergreifen, um vorzugsweise dadurch ein Scharnier zu bilden (zwischen Haken und Scharnierbereich).

Dadurch können eine vereinfachte und/oder positionsgenauere Montage sowie ein (flächiges) Komprimieren des Wärmeleitmittels ermöglicht werden, insbesondere indem erst ein Untergreifen und anschließend ein Andrücken des Wärmeaufnahmebereichs, insbesondere der ersten und/oder zweiten Lasche durchgeführt wird. Der erste und/oder zweite Kühlkörper können eine Gitterstruktur und/oder Kühlrippen aufweisen. Dabei kann der Haken, insbesondere der erste und/oder zweite Haken, als teilweise und/oder angeschnittene Kühlrippe ausgebildet sein, vorzugsweise mit einer Längserstreckung entlang der y-Richtung und/oder einer Öffnung entlang (insbesondere entgegen) der x-Richtung. Dabei kann der Haken, insbesondere der erste und/oder zweite Haken, eine Lasche aufweisen, welche vorzugsweise in Richtung des Arbeitsabschnitts weisend ausgestaltet ist, insbesondere um dadurch den Haken zu bilden. Der Scharnierbereich, insbesondere ein erster und/oder zweiter Scharnierbereich, kann dabei im vordersten Bereich (entlang der x-Richtung) des Wärmeaufnahmebereichs, insbesondere einer ersten und/oder zweiten Lasche, angeordnet sein. Durch den Scharnierbereich und/oder den Haken kann eine flexible Befestigung ermöglicht werden. Dadurch können Flexibilität und/oder Stabilität (weiter) verbessert werden.

Im Rahmen der Erfindung ist es denkbar, dass der Wärmeabgabebereich zumindest einen seitlichen Wärmeabgabebereich, insbesondere einen ersten und einen zweiten seitlichen Wärmeabgabebereich, aufweist, welcher insbesondere in einem montierten Zustand rechtwinklig zu einem zentralen Wärmeabgabebereich anordbar ist.

Dabei kann der Wärmeabgabebereich aufweisen:
- einen seitlichen, flächigen, (bezogen auf die y-Richtung) linken und/oder ersten Wärmeabgabebereich,
- einen seitlichen, flächigen, (bezogen auf die y-Richtung) rechten und/oder zweiten Wärmeabgabebereich,
- einen flächigen, (bezogen auf die x-Richtung) vorderen und/oder dritten Wärmeabgabebereich,
- einen flächigen, (bezogen auf die x-Richtung) hinteren und/oder vierten Wärmeabgabebereich, und/oder
- einen zentralen, mittigen, flächigen, planaren und/oder senkrecht zur z-Richtung ausgebildeten Wärmeabgabebereich, welcher insbesondere in einem montierten Zustand rechtwinklig zu einem zentralen Wärmeabgabebereich anordbar/angeordnet ist.

Dabei können die vorbezeichneten Wärmeabgabebereiche (erster, zweiter, dritter, vierter, zentraler Wärmeabgabebereich) jeweils nach unten und/oder entlang (bzw. entgegen) der z-Richtung (beispielsweise durch Umbiegen) ausgebildet sein und vorzugsweise in den Motorraum ragen. Dadurch kann eine vergrößerte Fläche für einen (verbesserten) Wärmeaustausch mit dem Arbeitsabschnitt, insbesondere mit dem Motorraum, bereitgestellt werden. Dabei können die vorbezeichneten Wärmeabgabebereiche eine vereinfachte Montage bereitstellen, beispielsweise indem diese als Montagehilfe relativ zu dem Gehäuse verwendet werden. Alternativ oder zusätzlich kann es vorgesehen sein, dass ein Einführen in komplementär ausgebildete Schlitze (des Gehäuses und/oder des Motorraums) vorgesehen ist. Es kann vorgesehen sein, dass ein Übergang zwischen dem ersten und zentralen Wärmeabgabebereich abgerundet ausgestaltet ist. Dadurch können eine einfachere Fertigung (z. B. Biegen), erhöhte Stabilität und/oder erhöhte Flexibilität bereitgestellt werden. Dabei kann eine verbesserte Stabilität (Schutz) gegen externe mechanische Kräfte (Schutz bei Sturz der Küchenmaschine) ermöglicht werden. Es kann darüber hinaus vorgesehen sein, dass ein Übergang zwischen dem zweiten und zentralen Wärmeabgabebereich abgerundet ausgestaltet ist. Dadurch können eine einfachere Fertigung, erhöhte Stabilität und/oder erhöhte Flexibilität bereitgestellt werden. Es kann zudem vorgesehen sein, dass ein Übergang zwischen dem dritten und zentralen Wärmeabgabebereich abgerundet ausgestaltet ist. Dadurch können eine einfachere Fertigung, erhöhte Stabilität und/oder erhöhte Flexibilität bereitgestellt werden. Es kann ebenfalls vorgesehen sein, dass ein Übergang zwischen dem vierten und zentralen Wärmeabgabebereich abgerundet ausgestaltet ist. Dadurch können eine einfachere Fertigung, erhöhte Stabilität und/oder erhöhte Flexibilität bereitgestellt werden. Zudem können dadurch (jeweils) Toleranzen besser ausgeglichen werden.

Es kann im Rahmen der Erfindung vorgesehen sein, dass die Kühlkörpererweiterung für eine passive und/oder lüfterlose Wärmeabführung eingerichtet ist, insbesondere von einem zu kühlenden Elektronikabschnitt der Küchenmaschine.

Dabei kann die Wärme von dem Elektronikabschnitt primär und/oder ausschließlich durch die Kühlkörpererweiterung erfolgen. Es kann auch vorgesehen sein, dass die Kühlkörpererweiterung eine zusätzliche Wärmeabfuhr (zu bereits bestehenden Wärmeübertragungseinheiten) bereitstellt. Es kann auch vorgesehen sein, dass die Kühlkörpererweiterung als Erweiterungsmodul für (bestehende) Küchenmaschinen eingerichtet ist.

Es kann vorgesehen sein, dass der Wärmeabgabebereich zumindest einen, vorzugsweise zumindest zwei (z. B. links und rechts angeordnete) Einbauvorsprung bzw. Einbauvorsprünge, aufweist, welcher vorzugsweise als nach unten weisende und/oder senkrecht zu dem (flächigen Teil des) Wärmeabgabebereich(s) ausgestaltete Laschen ausgebildet sind. Dadurch kann eine einfachere Montage, insbesondere an komplementär ausgestalteten Ausnehmungen am Gehäuse der Küchenmaschine, erfolgen. Dadurch kann (auch) die Robustheit weiter erhöht werden. Der Einbauvorsprung kann (jeweils) durch Stanzen und/oder Biegen ausgebildet werden.

Auch ist es denkbar, dass die Kühlkörpererweiterung ein Stanz- und/oder Biegeteil ist, welches insbesondere einstückig und/oder materialeinheitlich ausgestaltet sein kann. Dabei kann das Stanzteil aus einem flachen Formkörper, wie z. B. blechartigen Material, zunächst ausgestanzt werden (und weist somit eine Grundform auf), um es anschließend in die gewünschte Endform (auch Einbauform genannt) durch Biegen umzuformen. Dabei können die erwähnten Scharniere, insbesondere Filmscharniere, an der Kühlkörpererweiterung durch das Umbiegen ausgebildet werden. Auch ist es möglich, dass in einem weiteren Schritt eine teilweise oder vollständige Beschichtung oder Lackierung der Oberfläche der Kühlkörpererweiterung (in seiner Endform) erfolgt, um beispielsweise zumindest eine gute Korrosionsbeständigkeit oder elektrische Isolation zu erzielen.

In der bisherigen Beschreibung und den vorliegenden Ansprüchen wird die Kühlkörpererweiterung in ihrer Endform beschrieben.

Die obenstehende Aufgabe wird gemäß einem zweiten Aspekt gelöst durch eine erfindungsgemäße Küchenmaschine, aufweisend:
- eine Kühlkörpererweiterung gemäß dem ersten Aspekt,
- einen zu kühlenden Elektronikabschnitt, umfassend zumindest ein (wärmeerzeugendes) elektronisches Bauteil, vorzugsweise eine Vielzahl elektronischer Bauteile,
- einen wärmeabführenden Arbeitsabschnitt der Küchenmaschine, welcher dazu eingerichtet ist, entstandene Wärme aus dem wärmeabführenden Arbeitsabschnitt (z. B. von Heizung und/oder Motor), und durch die Kühlkörpererweiterung aus dem zu kühlenden Elektronikabschnitt an den wärmeabführenden Arbeitsabschnitt geleitete Wärme, an eine Umgebung abzuführen.

Dabei können der Elektronik- und Arbeitsabschnitt räumlich getrennt und/oder thermisch voneinander isoliert sein. Dadurch kann der Elektronikabschnitt vor überhöhter Temperatur geschützt und/oder der Verschleiß reduziert und/oder die Sicherheit erhöht werden.

Damit ergeben sich in Bezug auf eine erfindungsgemäße Küchenmaschine die gleichen Vorteile, wie sie bereits in Bezug auf eine erfindungsgemäße Kühlkörpererweiterung beschrieben worden sind.

Es ist ferner denkbar, dass die Küchenmaschine ein insbesondere flaches und/oder (vorne) schräges Gehäuse aufweist, in welchem die Kühlkörpererweiterung, der zu kühlende Elektronikabschnitt und der wärmeabführende Arbeitsabschnitt angeordnet sind. Dabei ist die Kühlkörpererweiterung in dem wärmeabführenden Arbeitsabschnitt des Gehäuses mit einer Wärmeaustauschfläche zur Abgabe von Wärme an die Umgebung und/oder mit einem darunterliegenden, insbesondere temperierten, Motorraum, insbesondere thermisch leitend und/oder mechanisch, verbunden.

Dabei kann die Wärmeaustauschfläche einen Teil des Gehäuses (an der Oberseite) bilden, insbesondere dort integriert sein. Die Wärmeaustauschfläche kann als, insbesondere durch die Heizung temperierte, Heizplatte und/oder Herdplatte verwendet werden. Der Motorraum kann eine Temperierungseinheit, insbesondere (bevorzugt) eingerichtet zum Kühlen und/oder Heizen, aufweisen. Eine Temperierungseinheit kann einen Lüfter und/oder eine Wasserkühlung aufweisen (siehe oben).

Es kann vorgesehen sein, dass eine thermische Verbindung dabei durch ein zumindest abschnittsweises Berühren und/oder Ineinandergreifen von Kühlkörpererweiterung und Wärmeaustauschfläche und/oder Motorraum realisiert wird. Dabei kann auch eine Wärmebrücke, beispielsweise durch eine Wärmeleitpaste, dazwischenliegend verwendet werden. Alternativ oder zusätzlich kann ein Wärmeaustausch dabei über dazwischenliegende Luft erfolgen. Es kann vorgesehen sein, dass eine mechanische Verbindung, insbesondere eine kraftschlüssige und/oder formschlüssige Verbindung vorgesehen ist, wobei beispielsweise die Kühlkörpererweiterung mit der Wärmeaustauschfläche und/oder dem Motorraum (mechanisch) verbunden sein kann.

Auch ist es denkbar, dass insbesondere nur der wärmeabführende Arbeitsabschnitt zum Abführen von Wärme an die Umgebung eingerichtet ist.

Dabei kann im Wesentlichen nur, ausschließlich, primär und/oder in erster Linie der wärmeabführende Arbeitsabschnitt zum Abführen von Wärme an die Umgebung eingerichtet sein. Dadurch kann vorteilhafterweise der Elektronikbereich, insbesondere der den Elektronikabschnitt umgebende Teil des Gehäuses, beispielsweise eine Anzeigeeinheit, eine (vergleichsweise) geringe(re) Temperatur aufweisen.

Die obenstehende Aufgabe wird gemäß einem dritten Aspekt gelöst durch ein erfindungsgemäßes Montageverfahren, um eine Kühlkörpererweiterung gemäß dem ersten Aspekt in einer Küchenmaschine gemäß dem zweiten Aspekt zu montieren, aufweisend:
- Bereitstellen der Kühlkörpererweiterung und der Küchenmaschine,
- Einfügen der Kühlkörpererweiterung in die Küchenmaschine, wodurch ein zu kühlender Elektronikabschnitt der Küchenmaschine mit einem Wärmeaufnahmebereich der Kühlkörpererweiterung thermisch leitend verbunden wird (insbesondere durch Einbringen eines [ersten und/oder zweiten] Wärmeleitmittels), und wobei ein Wärmeabgabebereich der Kühlkörpererweiterung mit einem wärmeabführenden Arbeitsabschnitt der Küchenmaschine thermisch leitend verbunden wird (insbesondere durch Einbringen eines [dritten] Wärmeleitmittels), um insbesondere einen montierten Zustand zu erhalten.

Durch das Montageverfahren kann ein Erhalten von einem montierten Zustand ermöglicht werden. Bei dem Einfügen der Kühlkörpererweiterung in die Küchenmaschine werden die seitlichen Wärmeabgabebereiche an dem bzw. an das Gehäuse der Küchenmaschine geführt. Zusätzlich oder alternativ kann ein Untergreifen des Hakens, insbesondere ersten und/oder zweiten Hakens, durch den Wärmeaufnahmebereich, insbesondere die erste und/oder zweite Lasche, durchgeführt werden. Dabei kann ein Einfügen eines Wärmeleitmittels, insbesondere eines ersten und/oder zweiten Wärmeleitmittels, zwischen der ersten und/oder zweiten Lasche und dem ersten und/oder zweiten Kühlkörper erfolgen. Zusätzlich kann es vorgesehen sein, dass der Wärmeabgabebereich mit der Wärmeaustauschfläche und/oder dem Motorraum (thermisch leitend) verbunden wird, insbesondere durch ein (drittes) Wärmeleitmittel (siehe analog Ausführungen oben zum ersten und/oder zweiten Wärmeleitmittel). Dabei kann (jeweils) anschließend ein Aushärten des Wärmeleitmittels, insbesondere durch Temperieren (beispielsweise durch einen Heißluftfön) durchgeführt werden. Dabei kann ein Kompensieren von (überschüssigem) Wärmeleitmittel durch die Aussparung, insbesondere die erste und/oder zweite Aussparung, ermöglicht werden.

Damit ergeben sich in Bezug auf ein erfindungsgemäßes Montageverfahren die gleichen Vorteile, wie sie bereits in Bezug auf eine erfindungsgemäße Kühlkörpererweiterung und/oder eine erfindungsgemäße Küchenmaschine beschrieben worden sind.

Im Rahmen der Erfindung ist es optional möglich, dass bei dem Einfügen ein Wärmeaufnahmebereich der Kühlkörpererweiterung, insbesondere eine erste und/oder zweite Lasche, einen Scharnierbereich aufweist, welcher einen Haken, insbesondere einen ersten und/oder zweiten Haken eines Kühlkörpers der Küchenmaschine, insbesondere eines ersten und/oder zweiten Kühlkörpers, untergreift.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei zeigen beispielhaft
- Figur 1: ein Verfahren,
- Figur 2: eine Kühlkörpererweiterung in einer Grundform in Draufsicht,
- Figur 3: eine Kühlkörpererweiterung in einer Grundform in Schrägansicht,
- Figur 4: eine Kühlkörpererweiterung in einer Endform in einer Draufsicht,
- Figur 5: eine Kühlkörpererweiterung in einer Endform in Schrägansicht,
- Figur 6: eine Kühlkörpererweiterung in einer Endform in weiterer Schrägansicht, und
- Figur 7: eine Küchenmaschine mit einer eingebauten Kühlkörpererweiterung.

In den nachfolgenden Figuren werden für die gleichen technischen Merkmale, auch von unterschiedlichen Ausführungsbeispielen, die identischen Bezugszeichen verwendet.

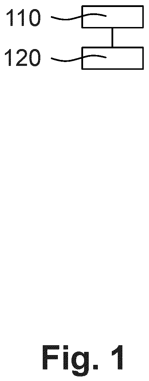

Fig. 1 zeigt ein Montageverfahren, um eine Kühlkörpererweiterung 100 in einer Küchenmaschine 200 zu montieren, aufweisend:
- Bereitstellen 110 der Kühlkörpererweiterung 100 und der Küchenmaschine 200,
- Einfügen 120 der Kühlkörpererweiterung 100 in die Küchenmaschine 200, wodurch ein zu kühlender Elektronikabschnitt 210 der Küchenmaschine 200 mit einem Wärmeaufnahmebereich 10 der Kühlkörpererweiterung 100 thermisch leitend verbunden wird, und wobei ein Wärmeabgabebereich 30 der Kühlkörpererweiterung 100 mit einem wärmeabführenden Arbeitsabschnitt 230 der Küchenmaschine 200 thermisch leitend verbunden wird, um insbesondere einen montierten Zustand zu erhalten.

Im Rahmen der Erfindung ist es optional möglich, dass bei dem Einfügen 120 ein Wärmeaufnahmebereich 10 der Kühlkörpererweiterung 100, insbesondere eine erste Lasche 11 und/oder zweite Lasche 12, einen Scharnierbereich 5.1, 5.2 aufweist, welcher einen Haken 205, insbesondere einen ersten Haken 205.1 und/oder zweiten Haken 205.2, eines Kühlkörpers 211, 212 der Küchenmaschine 200, insbesondere eines ersten Kühlkörpers 211 und/oder zweiten Kühlkörpers 212, untergreift.

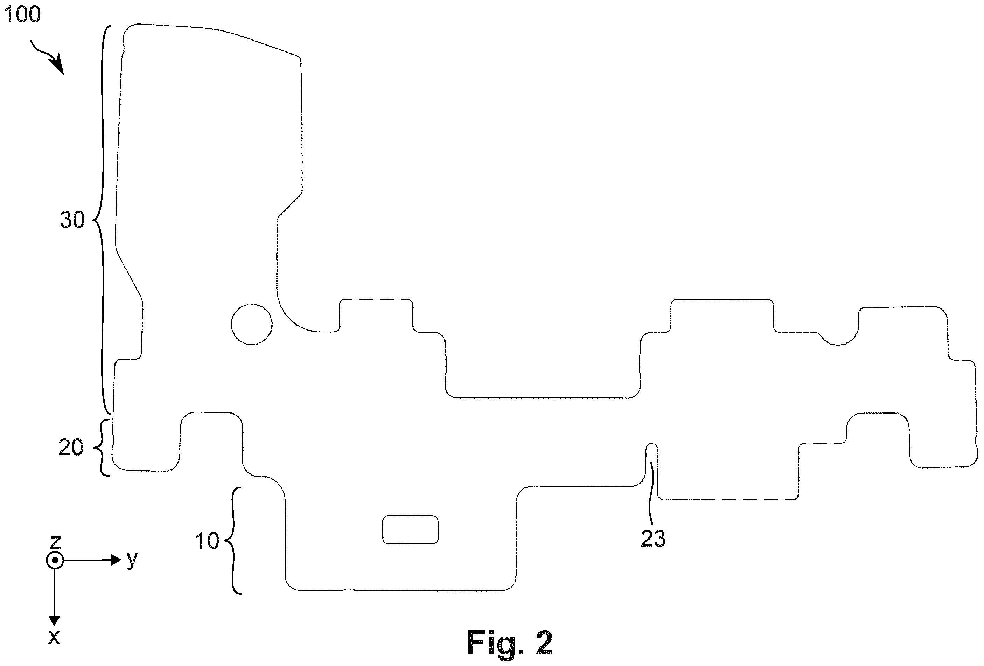

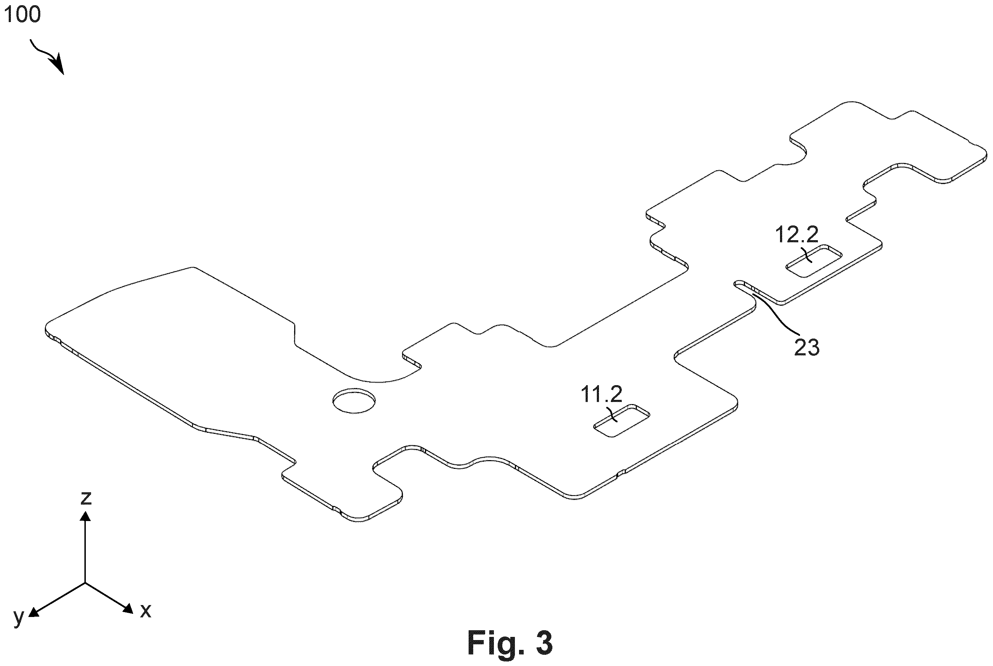

Fig. 2 und Fig. 3 zeigen eine Kühlkörpererweiterung 100, wie sie beispielsweise (vor einem Biegen) als Stanzteil, insbesondere aufweisend einen flachen Formkörper, z. B. ein Blech, in einer Grundform - also beispielsweise nach dem Ausstanzen - ausgestaltet sein kann.

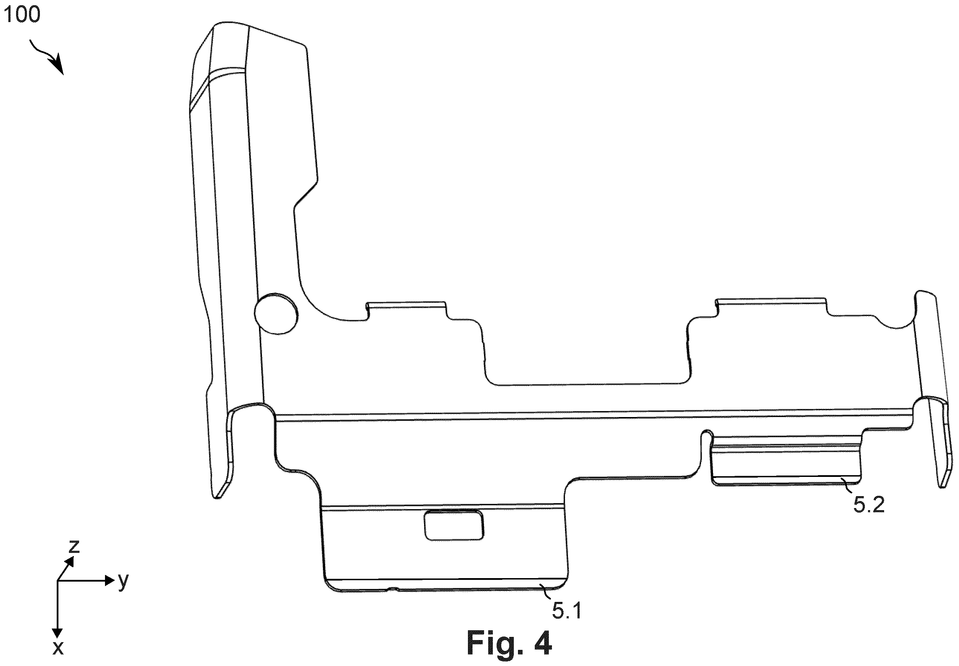

Dabei zeigen die Fig. 4 bis 6 die (fertige und/oder gebogene) Kühlkörpererweiterung 100 in einer Endform. In dieser Endform kann die Kühlkörpererweiterung 100 in eine entsprechende Küchenmaschine 200 eingebaut werden.

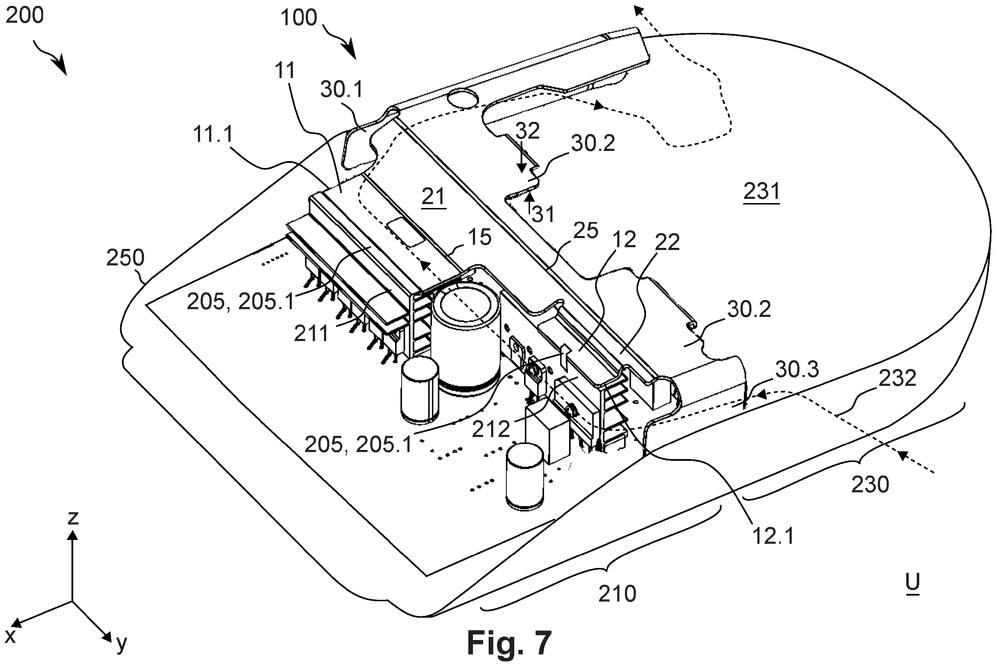

Die Fig. 2 bis 6 zeigen beispielhaft in unterschiedlichen Orientierungen eine Kühlkörpererweiterung 100 für eine Küchenmaschine 200 (vgl. Fig. 7), aufweisend:
- einen Wärmeaufnahmebereich 10, der thermisch leitend mit einem zu kühlenden Elektronikabschnitt 210 einer Küchenmaschine 200 verbindbar ist,
- einen Wärmeabgabebereich 30, der thermisch leitend mit einem wärmeabführenden Arbeitsabschnitt 230 der Küchenmaschine 200 verbindbar ist,
- einen Übergangsbereich 20, der den Wärmeaufnahmebereich 10 und den Wärmeabgabebereich 30 thermisch leitend verbindet und dazu eingerichtet ist, Wärme von dem Wärmeaufnahmebereich 10 an den Wärmeabgabebereich 30 zu leiten.

Im Rahmen der Erfindung kann es von Vorteil sein, dass der Wärmeaufnahmebereich 10, der Wärmeabgabebereich 30 und/oder der Übergangsbereich 20 flächig ausgestaltet sind, wobei insbesondere in einem montierten Zustand der Wärmeaufnahmebereich 10 und der Wärmeabgabebereich 30 im Wesentlichen parallel anordbar sind.

Im Rahmen der Erfindung ist es denkbar, dass der Übergangsbereich 20 relativ zu dem Wärmeaufnahmebereich 10 und dem Wärmeabgabebereich 30 abgewinkelt ausgestaltet ist, insbesondere in einem montierten Zustand, wobei vorzugsweise zwischen dem Übergangsbereich 20 und dem Wärmeaufnahmebereich 10 ein spitzer Winkel ausgebildet ist und/oder zwischen dem Übergangsbereich 20 und dem Wärmeabgabebereich 30 ein spitzer Winkel ausgebildet ist.

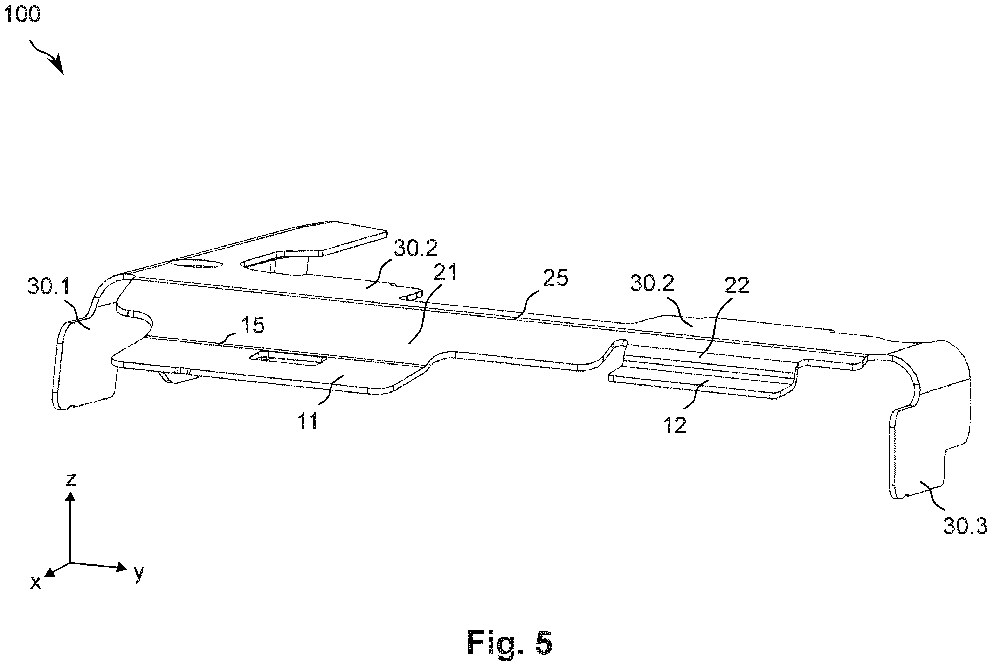

Wie Fig. 5 bis 7 zeigen, kann es im Rahmen der Erfindung vorgesehen sein, dass insbesondere in einem montierten Zustand der Wärmeaufnahmebereich 10, insbesondere relativ zu einer vertikalen z-Richtung z, unterhalb des Wärmeabgabebereichs 30 angeordnet ist und/oder der Übergangsbereich 20 schräg dazwischenliegend angeordnet ist.

Es ist ferner denkbar, dass die Kühlkörpererweiterung 100 L-förmig ausgestaltet ist, insbesondere senkrecht zu einer z-Richtung z, welche sich senkrecht zu einer x-Richtung x und einer y-Richtung y erstreckt, wobei insbesondere an einer längeren Seite der Kühlkörpererweiterung 100 der Wärmeaufnahmebereich 10, der Übergangsbereich 20 und/oder der Wärmeabgabebereich 30 anordbar sind.

Auch ist es denkbar, dass der Übergangsbereich 20 durch ein erstes Scharnier 15 mit dem Wärmeaufnahmebereich 10, vorzugsweise stoffschlüssig, verbunden ist, und/oder der Übergangsbereich 20 durch ein zweites Scharnier 25, insbesondere stoffschlüssig, mit dem Wärmeabgabebereich 30 verbunden ist.

Im Rahmen der Erfindung ist es optional möglich, dass der Wärmeabgabebereich 30 eine obere Wärmeabgabefläche 32 aufweist, welche dazu eingerichtet ist, in dem wärmeabführenden Arbeitsabschnitt 230 der Küchenmaschine 200 Wärme, insbesondere über eine (obenliegende und/oder nach oben weisende) Wärmeaustauschfläche der Küchenmaschine 200, an die Umgebung U abzugeben, und dass er eine untere Wärmeabgabefläche 31 aufweist, welche dazu eingerichtet ist, in dem wärmeabführenden Arbeitsabschnitt 230 der Küchenmaschine 200 Wärme an einen Motorraum 231 der Küchenmaschine 200 abzugeben.

Ferner kann es im Rahmen der Erfindung vorgesehen sein, dass der Wärmeaufnahmebereich 10, insbesondere eine erste Lasche 11 und/oder zweite Lasche 12 des Wärmeaufnahmebereichs 10, dazu eingerichtet ist, durch ein Wärmeleitmittel 11.1, 12.2, insbesondere ein erstes Wärmeleitmittel 11.1 und/oder zweites Wärmeleitmittel 12.1, mit einem Kühlkörper 211, 212, insbesondere einem ersten Kühlkörper 211 und/oder zweiten Kühlkörper 212 des zu kühlenden Elektronikabschnitts 210 der Küchenmaschine 200 verbunden zu werden.

In Bezug auf die vorliegende Erfindung ist es vorstellbar, dass der Übergangsbereich 20 eine Ausnehmung 23 aufweist, welche dazu eingerichtet ist, zwei räumlich getrennte Übergangsbereiche 20, insbesondere einen ersten Übergangsbereich 21 für eine erste Lasche 11 und einen zweiten Übergangsbereich 22 für eine zweite Lasche 12, bereitzustellen.

Ferner ist es vorstellbar, dass der Wärmeaufnahmebereich 10, insbesondere eine erste Lasche 11 und/oder zweite Lasche 12, zumindest eine Aussparung 11.2, 12.2 aufweist, welche insbesondere rechteckig ausgestaltet ist.

Im Rahmen der Erfindung kann es von Vorteil sein, dass der Wärmeaufnahmebereich 10, insbesondere eine erste Lasche 11 und/oder zweite Lasche 12, einen Scharnierbereich 5.1, 5.2 aufweist, welcher dazu eingerichtet ist, insbesondere bei einer Montage, einen Haken 205, insbesondere einen ersten Haken 205.1 und/oder zweiten Haken 205.2 eines Kühlkörpers 211, 212, insbesondere eines ersten Kühlkörpers 211 und/oder zweiten Kühlkörpers 212, zu untergreifen.

Im Rahmen der Erfindung ist es denkbar, dass der Wärmeabgabebereich 30 zumindest einen seitlichen Wärmeabgabebereich 30.1, 30.3, insbesondere einen ersten seitlichen Wärmeabgabebereich 30.1 und einen zweiten seitlichen Wärmeabgabebereich 30.3, aufweist, welcher insbesondere in einem montierten Zustand rechtwinklig zu einem zentralen Wärmeabgabereich 30.2 anordbar ist.

Es kann im Rahmen der Erfindung vorgesehen sein, dass die Kühlkörpererweiterung 100 für eine passive und/oder lüfterlose Wärmeabführung eingerichtet ist, insbesondere von einem zu kühlenden Elektronikabschnitt 210 der Küchenmaschine 200.

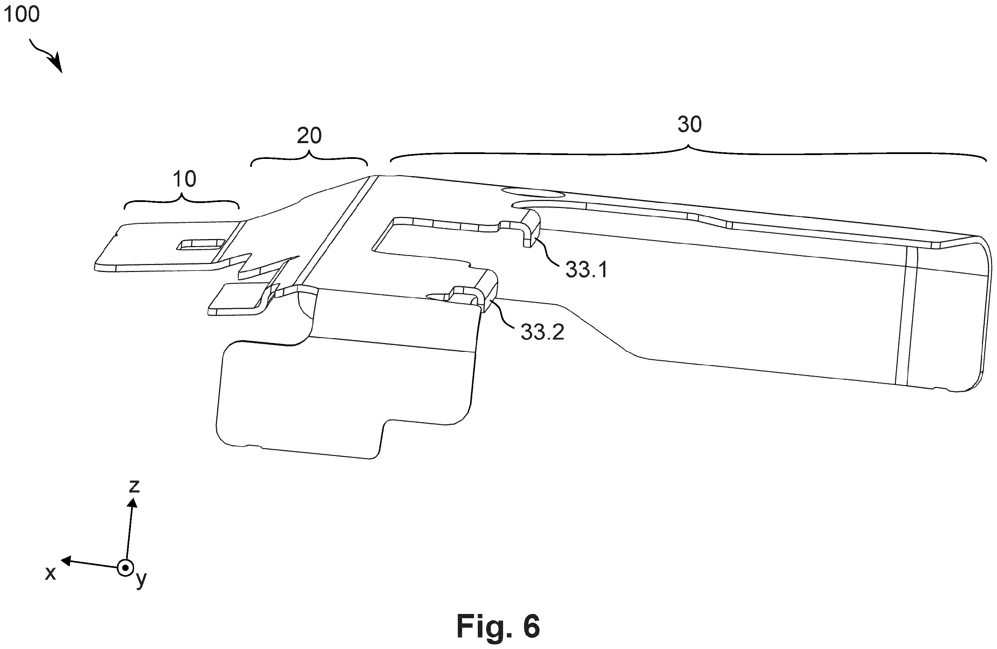

Fig. 7 zeigt eine Küchenmaschine 200, aufweisend:
- eine Kühlkörpererweiterung 100, insbesondere gemäß dem ersten Aspekt und/oder gemäß den Fig. 4, Fig. 5, und/oder Fig. 6,
- einen zu kühlenden Elektronikabschnitt 210 (z. B. aufweisend eine Platine), umfassend zumindest ein elektronisches Bauteil (z. B. Transistoren, Kondensatoren et cetera, siehe zylindrische Körper),
- einen wärmeabführenden Arbeitsabschnitt 230 der Küchenmaschine 200, welcher dazu eingerichtet ist, entstandene Wärme aus dem wärmeabführenden Arbeitsabschnitt 230 und durch die Kühlkörpererweiterung 100 aus dem zu kühlenden Elektronikabschnitt 210 an den wärmeabführenden Arbeitsabschnitt 230 geleitete Wärme an eine Umgebung U abzuführen.

Es ist ferner denkbar, dass die Küchenmaschine 200 ein insbesondere flaches Gehäuse 250 aufweist (gezeigt ist ein unterer Teil des Gehäuses 250), in welchem die Kühlkörpererweiterung 100, der zu kühlende Elektronikabschnitt 210 und der wärmeabführende Arbeitsabschnitt 230 angeordnet sind, wobei die Kühlkörpererweiterung 100 in dem wärmeabführenden Arbeitsabschnitt 230 des Gehäuses 250 mit einer Wärmeaustauschfläche zur Abgabe von Wärme an die Umgebung U und mit einem darunterliegenden, insbesondere temperierten, Motorraum 231, insbesondere thermisch leitend und/oder mechanisch, verbunden ist.

Auch ist es denkbar, dass insbesondere nur der wärmeabführende Arbeitsabschnitt 230 zum Abführen von Wärme an die Umgebung U eingerichtet ist. Dadurch kann Wärme, welche insbesondere (auch) im Elektronikabschnitt 210 entstehen kann, über den (dahinterliegenden) Arbeitsbereich 230 abgeführt werden, insbesondere ohne dass ein (primäres) Abführen der Wärme im Elektronikabschnitt 210 erfolgen müsste.

Zuletzt ist beispielhaft ein Lüftungskanal 232 und/oder der Weg von Luft aus der Umgebung dargestellt. Der Lüftungskanal 232 kann von einem Einlass im Gehäuse 250 (z. B. an einer rechten Seitenwand und/oder dem Motorraum 231) hin zu einem Auslass im Gehäuse 250 (z. B. an einer linken Seitenwand und/oder dem Motorraum 231) Luft zur Kühlung des Motorraums 231 und/oder des Elektronikabschnitts 210 und/oder der Kühlkörpererweiterung 100 führen. Dabei kann Luft in den Lüftungskanal 232 durch einen Motor, insbesondere ein Lüfterrad auf einer Drehwelle des Motors (welches sich mit dem Motor dreht), angesaugt werden. Beispielsweise kann so die Kühlkörpererweiterung 100 Wärme an den (abschnittsweise) unterhalb verlaufenden Lüftungskanal 232 bzw. darin befindliche Luft abgeben.

### Bezugszeichenliste

- 5.1, 5.2: Scharnierbereich
- 10: Wärmeaufnahmebereich
- 11: erste Lasche
- 11.1, 12.1: Wärmeleitmittel
- 11.1: erstes Wärmeleitmittel
- 11.2, 12.2: Aussparung
- 12: zweite Lasche
- 12.1: zweites Wärmeleitmittel
- 15: erstes Scharnier
- 20: Übergangsbereich
- 21: erster Übergangsbereich
- 22: zweiter Übergangsbereich
- 23: Ausnehmung
- 25: zweites Scharnier
- 30: Wärmeabgabebereich
- 30.1., 30.3: seitlicher Wärmeabgabebereich
- 30.1: erster seitlicher Wärmeabgabebereich
- 30.2: zentraler Wärmeabgabebereich
- 30.3: zweiter seitlicher Wärmeabgabebereich
- 31: untere Wärmeabgabefläche
- 32: obere Wärmeabgabefläche
- 33.1, 33.2: Einbauvorsprünge
- 100: Kühlkörpererweiterung
- 110: Bereitstellen
- 120: Einfügen
- 200: Küchenmaschine
- 205: Haken
- 205.1: erster Haken
- 205.2: zweiter Haken
- 210: Elektronikabschnitt
- 211,212: Kühlkörper
- 211: erster Kühlkörper
- 212: zweiter Kühlkörper
- 230: wärmeabführender Arbeitsabschnitt
- 231: Motorraum
- 232: Lüftungskanal
- 250: Gehäuse
- U: Umgebung
- x: x-Richtung
- y: y-Richtung
- z: z-Richtung

## Patentansprüche

1. Kühlkörpererweiterung (100) für eine Küchenmaschine (200), aufweisend:
- einen Wärmeaufnahmebereich (10), der thermisch leitend mit einem zu kühlenden Elektronikabschnitt (210) einer Küchenmaschine (200) verbindbar ist,
- einen Wärmeabgabebereich (30), der thermisch leitend mit einem wärmeabführenden Arbeitsabschnitt (230) der Küchenmaschine (200) verbindbar ist,
- einen Übergangsbereich (20), der den Wärmeaufnahmebereich (10) und den Wärmeabgabebereich (30) thermisch leitend verbindet und dazu eingerichtet ist, Wärme von dem Wärmeaufnahmebereich (10) an den Wärmeabgabebereich (30) zu leiten.

2. Kühlkörpererweiterung (100) nach Anspruch 1,
**dadurch gekennzeichnet,**
**dass** der Übergangsbereich (20) relativ zu dem Wärmeaufnahmebereich (10) und dem Wärmeabgabebereich (30) abgewinkelt ausgestaltet ist, insbesondere in einem montierten Zustand, wobei vorzugsweise zwischen dem Übergangsbereich (20) und dem Wärmeaufnahmebereich (10) ein spitzer Winkel ausgebildet ist und/oder zwischen dem Übergangsbereich (20) und dem Wärmeabgabebereich (30) ein spitzer Winkel ausgebildet ist,
und/oder
**dass**, insbesondere in einem montierten Zustand, der Wärmeaufnahmebereich (10), insbesondere relativ zu einer vertikalen z-Richtung (z), unterhalb des Wärmeabgabebereichs (30) angeordnet ist und/oder der Übergangsbereich (20) schräg dazwischenliegend angeordnet ist.

3. Kühlkörpererweiterung (100) nach einem der vorhergehenden Ansprüche,
**dadurch gekennzeichnet,**
**dass** die Kühlkörpererweiterung (100) L-förmig ausgestaltet ist, insbesondere senkrecht zu einer z-Richtung (z), welche sich senkrecht zu einer x-Richtung (x) und einer y-Richtung (y) erstreckt, wobei insbesondere an einer längeren Seite der Kühlkörpererweiterung (100) der Wärmeaufnahmebereich (10), der Übergangsbereich (20) und/oder der Wärmeabgabebereich (30) anordbar sind.

4. Kühlkörpererweiterung (100) nach einem der vorhergehenden Ansprüche,
**dadurch gekennzeichnet,**
**dass** der Übergangsbereich (20) durch ein erstes Scharnier (15) mit dem Wärmeaufnahmebereich (10), vorzugsweise stoffschlüssig, verbunden ist, und/oder der Übergangsbereich (20) durch ein zweites Scharnier (25), insbesondere stoffschlüssig, mit dem Wärmeabgabebereich (30) verbunden ist.

5. Kühlkörpererweiterung (100) nach einem der vorhergehenden Ansprüche,
**dadurch gekennzeichnet,**
**dass** der Wärmeabgabebereich (30) eine obere Wärmeabgabefläche (32) aufweist, welche dazu eingerichtet ist, in dem wärmeabführenden Arbeitsabschnitt (230) der Küchenmaschine (200) Wärme, insbesondere über eine Wärmeaustauschfläche der Küchenmaschine (200), an die Umgebung (U) abzugeben, und eine untere Wärmeabgabefläche (31), und/oder welche dazu eingerichtet ist, in dem wärmeabführenden Arbeitsabschnitt (230) der Küchenmaschine (200) Wärme an einen Motorraum (231) der Küchenmaschine (200) abzugeben.

6. Kühlkörpererweiterung (100) nach einem der vorhergehenden Ansprüche,
**dadurch gekennzeichnet,**
**dass** der Wärmeaufnahmebereich (10), insbesondere eine erste Lasche (11) und/oder zweite Lasche (12) des Wärmeaufnahmebereichs (10), dazu eingerichtet ist, durch ein Wärmeleitmittel (11.1, 12.2), insbesondere ein erstes Wärmeleitmittel (11.1) und/oder zweites Wärmeleitmittel (12.1), mit einem Kühlkörper (211, 212), insbesondere einem ersten Kühlkörper (211) und/oder zweiten Kühlkörper (212), des zu kühlenden Elektronikabschnitts (210) der Küchenmaschine (200) verbunden zu werden.

7. Kühlkörpererweiterung (100) nach einem der vorhergehenden Ansprüche,
**dadurch gekennzeichnet,**
**dass** der Übergangsbereich (20) eine Ausnehmung (23) aufweist, welche dazu eingerichtet ist, zwei räumlich getrennte Übergangsbereiche (20), insbesondere einen ersten Übergangsbereich (21) für eine erste Lasche (11) und einen zweiten Übergangsbereich (22) für eine zweite Lasche (12), bereitzustellen.

8. Kühlkörpererweiterung (100) nach einem der vorhergehenden Ansprüche,
**dadurch gekennzeichnet,**
**dass** der Wärmeaufnahmebereich (10), insbesondere eine erste Lasche (11) und/oder zweite Lasche (12), zumindest eine Aussparung (11.2, 12.2) aufweist, welche insbesondere rechteckig ausgestaltet ist.

9. Kühlkörpererweiterung (100) nach einem der vorhergehenden Ansprüche,
**dadurch gekennzeichnet,**
**dass** der Wärmeaufnahmebereich (10), insbesondere eine erste Lasche (11) und/oder zweite Lasche (12), einen Scharnierbereich (5.1, 5.2) aufweist, welcher dazu eingerichtet ist, insbesondere bei einer Montage, einen Haken (205), insbesondere einen ersten Haken (205.1) und/oder zweiten Haken (205.2), eines Kühlkörpers (211, 212), insbesondere eines ersten Kühlkörpers (211) und/oder zweiten Kühlkörpers (212), zu untergreifen.

10. Kühlkörpererweiterung (100) nach einem der vorhergehenden Ansprüche,
**dadurch gekennzeichnet,**
**dass** der Wärmeabgabebereich (30) zumindest einen seitlichen Wärmeabgabebereich (30.1, 30.3), insbesondere einen ersten seitlichen Wärmeabgabebereich (30.1) und einen zweiten seitlichen Wärmeabgabebereich (30.3) aufweist, welcher insbesondere in einem montierten Zustand, rechtwinklig zu einem zentralen Wärmeabgabereich (30.2) anordbar ist.

11. Kühlkörpererweiterung (100) nach einem der vorhergehenden Ansprüche,
**dadurch gekennzeichnet,**
**dass** die Kühlkörpererweiterung (100) für eine passive und/oder lüfterlose Wärmeabführung eingerichtet ist, insbesondere von einem zu kühlenden Elektronikabschnitt (210) der Küchenmaschine (200), und/oder dass die Kühlkörpererweiterung (100) ein Stanz- und/oder Biegeteil ist.

12. Küchenmaschine (200), aufweisend:
- eine Kühlkörpererweiterung (100) nach einem der vorhergehenden Ansprüche,
- einen zu kühlenden Elektronikabschnitt (210), umfassend zumindest ein elektronisches Bauteil,
- einen wärmeabführenden Arbeitsabschnitt (230) der Küchenmaschine (200), welcher dazu eingerichtet ist, entstandene Wärme aus dem wärmeabführenden Arbeitsabschnitt (230), und durch die Kühlkörpererweiterung (100) aus dem zu kühlenden Elektronikabschnitt (210) an den wärmeabführenden Arbeitsabschnitt (230) geleitete Wärme, an eine Umgebung (U) abzuführen.

13. Küchenmaschine (200) nach dem vorhergehenden Anspruch,
**dadurch gekennzeichnet,**
**dass** die Küchenmaschine (200) ein, insbesondere flaches, Gehäuse (250) aufweist, in welchem die Kühlkörpererweiterung (100), der zu kühlende Elektronikabschnitt (210) und der wärmeabführende Arbeitsabschnitt (230) angeordnet sind, wobei die Kühlkörpererweiterung (100) in dem wärmeabführenden Arbeitsabschnitt (230) des Gehäuses (250) mit einer Wärmeaustauschfläche zur Abgabe von Wärme an die Umgebung (U) und mit einem darunterliegenden Motorraum (231), insbesondere thermisch leitend und/oder mechanisch, verbunden ist.

14. Montageverfahren, um eine Kühlkörpererweiterung (100) nach einem der vorhergehenden Ansprüche 1 bis 14 in einer Küchenmaschine (200) nach einem der vorhergehenden Ansprüche 15 bis 17 zu montieren, aufweisend:
- Bereitstellen (110) der Kühlkörpererweiterung (100) und der Küchenmaschine (200),
- Einfügen (120) der Kühlkörpererweiterung (100) in die Küchenmaschine (200), wodurch ein zu kühlender Elektronikabschnitt (210) der Küchenmaschine (200) mit einem Wärmeaufnahmebereich (10) der Kühlkörpererweiterung (100) thermisch leitend verbunden wird, und wobei ein Wärmeabgabebereich (30) der Kühlkörpererweiterung (100) mit einem wärmeabführenden Arbeitsabschnitt (230) der Küchenmaschine (200) thermisch leitend verbunden wird, um insbesondere einen montierten Zustand zu erhalten.

15. Montageverfahren nach dem vorhergehenden Anspruch,
**dadurch gekennzeichnet,**
**dass** bei dem Einfügen (120) ein Wärmeaufnahmebereich (10) der Kühlkörpererweiterung (100), insbesondere eine erste Lasche (11) und/oder zweite Lasche (12), einen Scharnierbereich (5.1, 5.2) aufweist, welcher einen Haken (205), insbesondere einen ersten Haken (205.1) und/oder zweiten Haken (205.2), eines Kühlkörpers (211, 212) der Küchenmaschine (200), insbesondere eines ersten Kühlkörpers (211) und/oder zweiten Kühlkörpers (212), untergreift.
